# EUROPEAN PATENT SPECIFICATION

(11) **EP 0 978 872 B1**
(45) Date of publication and mention of the grant of the patent: **12.10.2011**
(21) Application number: 98830476.2
(22) Date of filing: 03.08.1998
(51) Int. Cl.: H01L 21/762

(54) **An inexpensive method of manufacturing an SOI wafer**
Ein preiswertes Verfahren zur Herstellung eines SOI-Wafers
Procédé économique de fabrication d'une puce SOI

(43) Date of publication of application: 09.02.2000
(73) Proprietor: STMicroelectronics Srl, 20041 Agrate Brianza (MB) (IT)
(72) Inventor: Mastromatteo, Ubaldo, 20010 Cornaredo (Milano) (IT); Villa, Flavio, 20159 Milano (IT); Barlocchi, Gabriele, 20010 Cornaredo (Milano) (IT)
(74) Representative: Mozzi, Matteo

(56) References cited:
- GB-A- 2 156 149
- US-A- 4 685 198
- US-A- 4 948 456
- PATENT ABSTRACTS OF JAPAN vol. 010, no. 113 (E-399), 26 April 1986 -& JP 60 249311 A (HITACHI SEISAKUSHO KK), 10 December 1985
- PATENT ABSTRACTS OF JAPAN vol. 006, no. 254 (E-148), 14 December 1982 -& JP 57 154855 A (TOKYO SHIBAURA DENKI KK), 24 September 1982

## Description

The present invention relates to a method of manufacturing an SOI wafer from a monocrystalline silicon substrate.

As is known, in the microelectronics industry, monocrystalline silicon wafers constitute the substrate most widely used for the manufacture of electronic devices. In recent years, as an alternative to silicon wafers, composite, so-called "SOI" (silicon on insulator) wafers, which are constituted by two silicon layers, one thinner than the other and separated by a silicon dioxide layer, have been proposed.

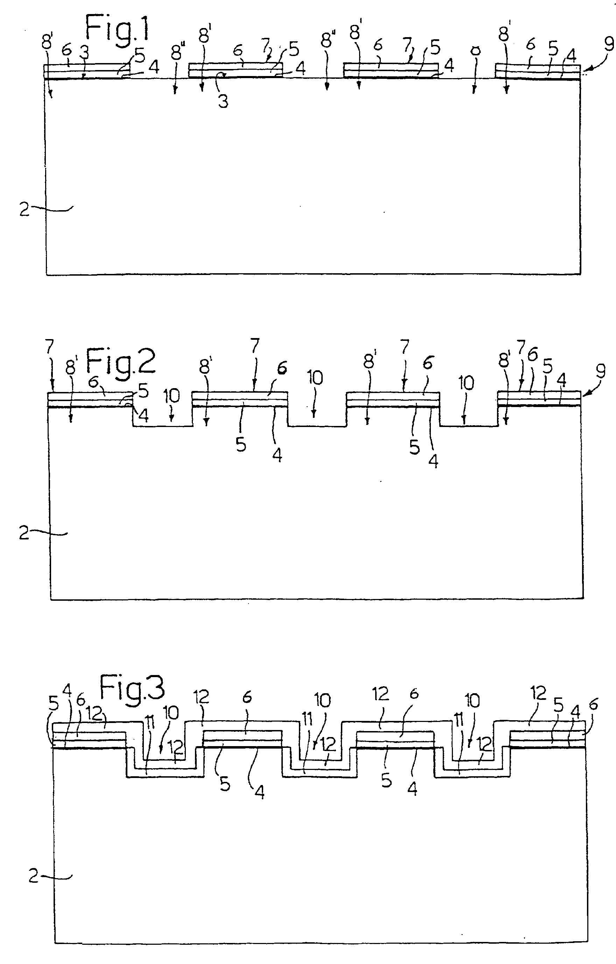

A method of manufacturing SOI wafers is the subject of European patent application EP-A-0929095 filed on 13.01.98 in the name of SGS-THOMSON MICROELECTRONICS S.r.l. A similar method is described below with reference to Figures 1 to 8.

First of all a first silicon dioxide layer between 20 and 60 nm thick is grown on a major surface 3 of a substrate constituted by a monocrystalline silicon wafer 2, and then a first layer of silicon nitride between 90 and 150 nm thick and a second silicon dioxide layer between 100 and 600 nm thick produced by decomposition of tetraethyl orthosilicate (TEOS), are deposited thereon. A resist layer and a masking operation are used to define in plan, for example, a grid of rectangular areas. Dry etching of the uncovered portions of the TEOS oxide layer, of the first nitride layer, and of the first oxide layer is then carried out and the residual resist is then removed producing the structure shown in section in Figure 1. The portions of the first oxide layer, of the first nitride layer, and of the TEOS oxide layer remaining after the dry etching are indicated 4, 5 and 6, respectively, and together define protective plaques 7 covering portions 8' of the monocrystalline silicon substrate 2.

The protective plaques 7 form a mask, generally indicated 9, for subsequent selective anisotropic etching of the silicon substrate 2. This treatment etches the portions of the substrate 2 indicated 8", which are not protected by the mask 9, so that initial trenches 10 are formed (Figure 2).

As shown in Figure 3, the structure is then subjected to an oxidation step which leads to the formation of a third silicon dioxide layer 11, between 20 and 60 nm thick, which covers the walls and the bases of the initial trenches 10. A second silicon nitride layer 12 between 90 and 150 nm thick is then deposited.

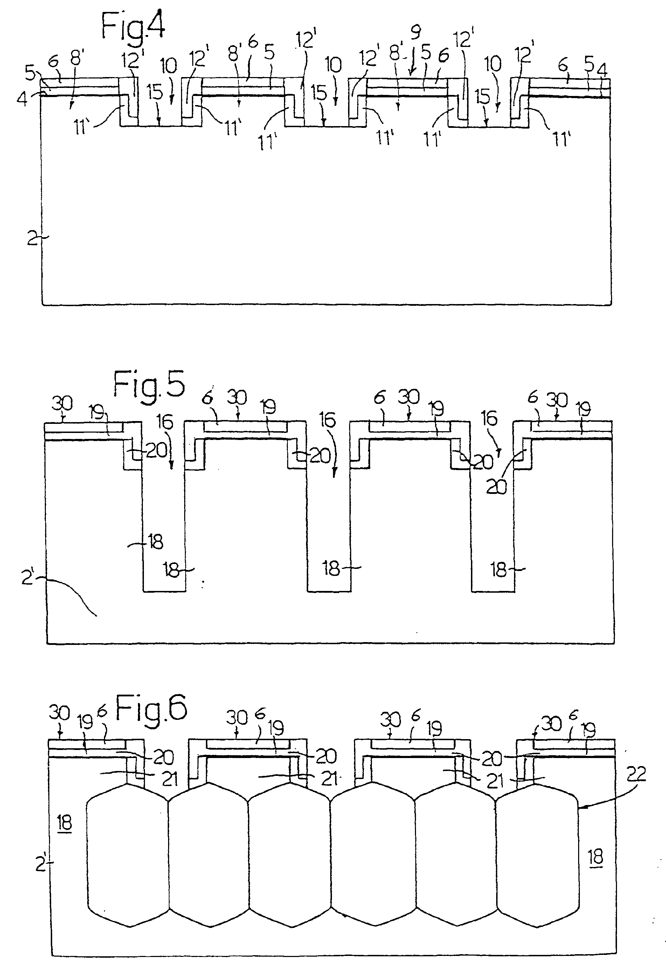

The method continues with dry anisotropic etching without masking, during which the horizontal portions of the second silicon nitride layer 12 are removed. During the dry etching, the first nitride layer 5 is protected by the TEOS oxide layer 6. The third oxide layer 11 which is disposed in the bases of the initial trenches 10 is removed by a wet process. This produces the structure shown in Figure 4, in which it is possible to see the portions 8', still covered on the top by the mask 9 and on the sides (on the vertical walls of the initial trenches 10) by portions 11' and 12' of oxide and nitride, respectively, and the uncovered bases 15 of the initial trenches 10.

Anisotropic etching of the silicon is then carried out with the use, as a mask, of the mask 9, modified by the addition of the oxide and nitride portions 11' and 12', respectively. The uncovered silicon in the bases 15 of the initial trenches 10 is etched for a predetermined period to give final trenches 16 having a desired depth. It will be noted that the difference between the depth of the final trenches 16 and that of the initial trenches 10 determines the dimensions of the buried oxide layer and hence the electrical characteristics of the SOI wafer, as will be explained further below. The etching depths are therefore selected on the basis of the specifications of the SOI wafer to be produced.

The monocrystalline silicon substrate thus treated is now formed by a base portion, indicated 2', and by a plurality of "pillars" 18 extending from the base portion 2'. The structure shown in Figure 5 is thus produced, in which the nitride portions 5 and 12' are no longer separate and are generally indicated 19, and the oxide portions 4 and 11' are generally indicated 20. The portions 19 and 20 with the overhanging TEOS oxide portions 6 form together a mask 30.

The silicon substrate is then subjected to selective oxidation with the use of the mask 30 to protect the silicon on the tops of the pillars 18 from oxidation. The process continues until the portions of the pillars 18 which are not protected by the mask 30 are completely converted into silicon dioxide. In practice, a gradual growth of the oxide regions takes place at the expense of the silicon regions, starting from the side walls of the final trenches 16, towards the interior of the pillars and partially also into the base portion 2'. Since the volume of silicon dioxide which is formed is greater than that of the initial silicon, the oxide regions being formed gradually occupy the space in the final trenches 16 until they close them completely and are joined together. The oxidation step terminates automatically when the pillars 18 are completely oxidized (naturally apart from their tops or tips, indicated 21, which are protected by the mask 30). A continuous oxide region 22 is thus formed, most of which is buried, as shown in Figure 6, in which vertical lines indicate the surfaces on which the oxide regions join.

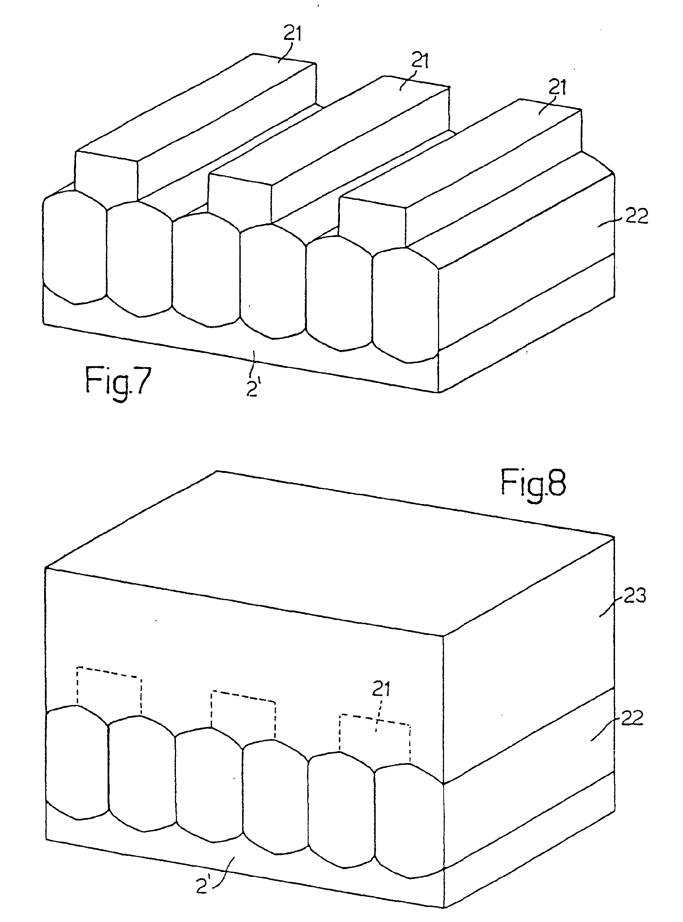

The TEOS oxide portions 6 and the nitride portions 19 and oxide portions 20 which constitute the mask 30 are then eliminated by selective etching so as to uncover the "tips" 21 which are intended to form the seeds for subsequent epitaxial growth. The resulting structure is shown in perspective in Figure 7. The epitaxial growth step is performed in a manner such as to prevent nucleation of polycrystalline silicon in the uncovered areas of the buried oxide region 22. Moreover, a high lateral/vertical growth ratio is selected so as to achieve, first of all, growth of the silicon sideways around the tips 21 until the trench portions which are still open are filled, and then growth of an epitaxial layer 23 in a direction perpendicular to the major surface of the substrate. After an optional chemico-mechanical lapping step to level the surface of the layer 23, the final structure of the SOI wafer shown in Figure 8 is obtained.

A SOI wafer is thus formed from a normal monocrystalline silicon substrate with the use purely of process steps which are common in microelectronics, with much lower costs than those of the methods currently used for the production of SOI wafers.

However, the implementation of the method described above imposes constraints. To produce a continuous buried oxide layer it is in fact necessary for the areas between adjacent trenches, which define the widths of the pillars, to be as narrow as possible. On the other hand, the minimum width of the pillars is fixed by the minimum thickness required for the residual monocrystalline silicon on the buried oxide layer (that is the "tips" 21 on the layer 22, with reference to Figure 7), to ensure an adequate crystallographic quality of the epitaxial layer subsequently grown. Moreover, the widths of the pillars cannot be as large as may be desired but must be selected so as to ensure that the silicon disposed between adjacent trenches is completely converted into oxide. It is also necessary for the trenches to be as narrow as possible consistent with the thicknesses required by the method for the nitride and oxide layers deposited or grown. Finally, the known method described above is greatly limited by the dimensional ratios between the trenches and the pillars.

Document GB-A-2 156 149 describes a method of manufacturing an integrated circuit comprising circuit elements formed in dielectrically-isolated semiconductor islands which are bounded at least at their bottom by insulating material.

The object of the present invention is to modify the known method so as to reduce this limitation.

This object is achieved by the implementation of the method according to the invention described and characterized in the first claim.

The invention will be understood better from the following detailed description of an embodiment thereof described by way of non-limiting example, with reference to the appended drawings, in which:
Figures 1 to 8 show,in section, a portion of an SOI wafer at successive stages of a known method, and
Figures 9 and 10 show, in section, a portion of an SOI wafer at two stages of the method according to the invention.

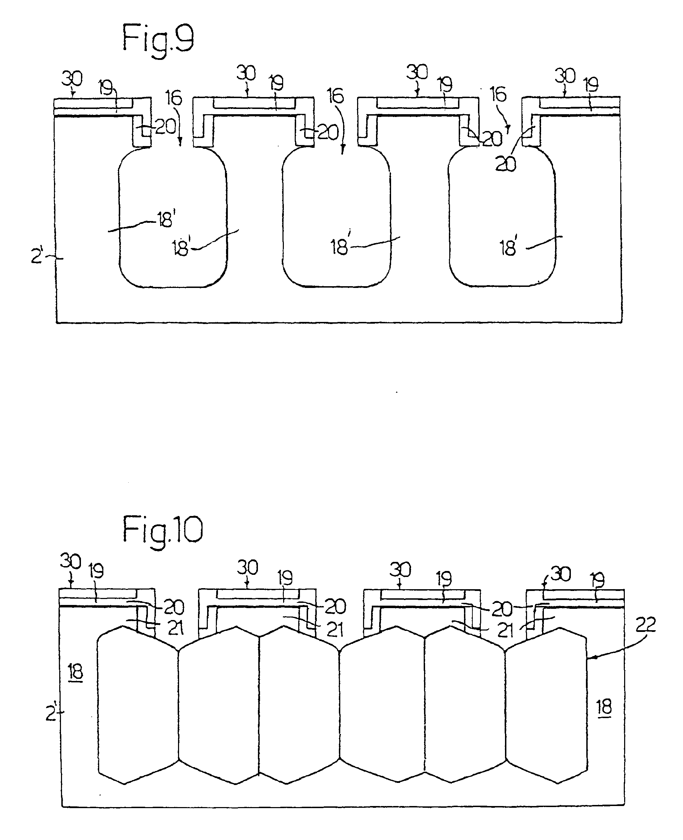

The method according to the invention differs from the known method described above in that, after the anisotropic etching in order to hollow out the final trenches 16 (Figure 5), and before the selective oxidation of the pillars 18, the silicon substrate is subjected to selective isotropic etching. This etching reduces the thickness of the pillars 18, starting a certain distance from the front surface of the substrate 2, that is, from the boundary of the mask 30. As a secondary effect, the depth of the trenches 16 increases. The structure resulting upon completion of the isotropic etching is substantially that shown in section in Figure 9, in which the pillars of reduced thickness are indicated 18'.

According to a preferred embodiment of the invention, the silicon substrate, protected by the mask 30 as shown in Figure 5, is exposed, in a reactor, to xenon difluoride (XeF₂) gas at ambient temperature with an etching rate of between 1 and 10 µm/min (depending on the geometry to be produced).

This type of etching is advantageous because it does not damage the silicon (as plasma etching, on the other hand, does), it is extremely highly selective with respect to the oxide (greater than 50:1), and it can be used without problems with regard to the safety of personnel and the integrity of the equipment. Clearly, however, the method according to the invention may also be implemented with isotropic etching of other types.

The method continues with a selective oxidation step similar to that of the known process described with reference to Figure 6. The portions of the substrate of reduced thickness, that is, the portions of the pillars 18' which are not protected by the mask 30, are converted into silicon dioxide. The resulting structure, shown in section in Figure 10, is substantially identical to that of Figure 6 produced by the known method. However, and this is the main advantage of the method according to the invention, the method according to the invention permits greater freedom in the selection of the dimensional ratios between the trenches and the pillars, ensuring the necessary crystallographic quality of the epitaxial layer grown and the formation of a continuous buried oxide layer. Moreover, with the method according to the invention, the most suitable ratio between the width of the trenches and the thickness of the pillars to be oxidized may be selected at the time in question, by adjustment of the isotropic etching time.

## Claims

1. A method of manufacturing an SOI wafer by subjecting a monocrystalline silicon substrate (2) to the following steps:
- anisotropically etching the substrate (2) to form shallow first trenches (10) between which first portions (8', 21) of the substrate (2) are defined;
- forming a mask (4, 5, 6, 11, 12) on the surface of the substrate and the sidewalls of the first trenches (10), which mask is resistant to oxidation and to etching processes used to etch silicon;
- using the mask to anisotropically etch the substrate and form second trenches (16) in the substrate, the second trenches (16) thus being narrower and deeper than the first trenches (10) and between which second trenches further portions (18) of the substrate are defined;
- isotropically etching the second trenches, whilst the mask protects the first trenches (10) from the etchant, thus reducing the thickness of the further portions of the substrate (18, 18') between adjacent second trenches (16);
- oxidising to completely convert the further substrate portions of reduced thickness (18') into silicon dioxide and continuing the oxidation until the second trenches (16) are filled with silicon dioxide, thus forming a continuous oxide region (22), the mask protecting the first portions of the substrate (8', 21) and the first trenches (10) from oxidation;
- removing the mask to expose the first substrate portions (21) between the first trenches (10); and
- epitaxially growing a silicon layer (23) on the exposed substrate portions (21) and then in a direction perpendicular to the major surface of the substrate to form a continuous epitaxial silicon layer over the exposed portions (21) of the substrate and the oxide region (22).

2. The method according to Claim 1, in which the mask (30) comprises a silicon nitride layer (19).

3. A method according to any one of the preceding claims, in which the selective isotropic etching is performed with xenon difluoride gas.

## Patentansprüche

1. Verfahren zum Herstellen eines SOI-Wafers, indem ein Substrat aus monokristallinem Silizium (2) folgenden Schritten unterzogen wird:
- anisotropes Ätzen des Substrats (2), um flache erste Gräben (10) zu bilden, zwischen denen erste Bereiche (8', 21) des Substrats (2) gebildet werden;
- Bilden einer Maske (4, 5, 6, 11, 12) an der Oberfläche des Substrats und an den Seitenwänden der ersten Gräben (10), wobei die Maske beständig gegen Oxidation sowie gegen Ätzprozesse ist, die zum Ätzen von Silizium verwendet werden;
- Verwenden der Maske zum anisotropen Ätzen des Substrats und zum Bilden von zweiten Gräben (16) in dem Substrat, wobei die zweiten Gräben (16) somit schmaler und tiefer sind als die ersten Gräben (10) und wobei zwischen den zweiten Gräben weitere Bereiche (18) des Substrats gebildet werden;
- isotropes Ätzen der zweiten Gräben, während die Maske die ersten Gräben (10) vor dem Ätzmittel schützt, so dass die Dicke der weiteren Bereiche des Substrats (18, 18') zwischen benachbarten zweiten Gräben (16) reduziert wird;
- Ausführen einer Oxidation zum vollständigen Umwandeln der weiteren Substratbereiche mit reduzierter Dicke (18') in Siliziumdioxid, und Fortsetzen der Oxidation, bis die zweiten Gräben (16) mit Siliziumdioxid gefüllt sind, um **dadurch** einen kontinuierlichen Oxidbereich (22) zu bilden, wobei die Maske die ersten Bereiche des Substrats (8', 21) und die ersten Gräben (10) vor Oxidation schützt;
- Entfernen der Maske, um die ersten Substratbereiche (21) zwischen den ersten Gräben (10) freizulegen; und
- epitaxiales Aufwachsen-lassen einer Siliziumschicht (23) auf den freiliegenden Substratbereichen (21) und dann in einer Richtung rechtwinklig zu der Hauptachse des Substrats, um eine kontinuierliche epitaxiale Siliziumschicht über den freiliegenden Bereichen (21) des Substrats und des Oxidbereichs (22) zu bilden.

2. Verfahren nach Anspruch 1,
wobei die Maske (30) eine Siliziumnitridschicht (19) aufweist.

3. Verfahren nach einem der vorausgehenden Ansprüche,
wobei das selektive isotrope Ätzen unter Verwendung von Xenondifluoridgas ausgeführt wird.

## Revendications

1. Procédé de fabrication d'une plaquette SOI en soumettant un substrat de silicium monocristallin (2) aux étapes suivantes qui consistent :
à attaquer de manière anisotrope le substrat (2) pour former des premières tranchées peu profondes (10) entre lesquelles des premières parties (8', 21) du substrat sont définies ;
à former un masque (4, 5, 6, 11, 12) sur la surface du substrat et des parois latérales des premières tranchées (10), lequel masque est résistant à l'oxydation et aux processus d'attaque utilisés pour attaquer le silicium ;
à utiliser le masque pour attaquer de manière anisotrope le substrat et pour former des deuxièmes tranchées (16) dans le substrat, les deuxième tranchées (16) étant ainsi plus étroites et plus profondes que les premières tranchées (10) et entre lesquelles des parties supplémentaires des deuxièmes tranchées (18) du substrat sont définies ;
à attaquer de manière isotrope les deuxièmes tranchées, alors que le masque protège les premières tranchées (10) de l'agent d'attaque, réduisant ainsi l'épaisseur des parties supplémentaires du substrat (18, 18') entre les deuxièmes tranchées adjacentes (16) ;
à oxyder pour convertir complètement les parties supplémentaires du substrat d'épaisseur réduite (18') en dioxyde de silicium et à continuer l'oxydation jusqu'à ce que les deuxièmes tranchées (16) soient remplies avec le dioxyde de silicium, formant ainsi une zone d'oxydation continue (22), le masque protégeant les premières parties du substrat (8', 21) et les premières tranchées de l'oxydation ;
à retirer le masque pour exposer les premières parties du substrat (21) entre les premières tranchées (10) ; et
à assurer la croissance épitaxiale d'une couche de silicium (23) sur les parties du substrat exposées (21) et ensuite dans une direction perpendiculaire à la surface principale du substrat pour former une couche de silicium épitaxiale continue sur les parties exposées (21) du substrat et la zone d'oxydation (22).

2. Procédé selon la revendication 1, dans lequel le masque (30) comprend une couche de nitrure de silicium (19).

3. Procédé selon l'une quelconque des revendications précédentes, dans lequel l'attaque isotrope sélective est réalisée avec un gaz de difluorure de xénon.
